# EUROPÄISCHE PATENTANMELDUNG

(11) **EP 0 836 372 A2**
(43) Veröffentlichungstag der Anmeldung: **15.04.1998**
(21) Anmeldenummer: 97117153.3
(22) Anmeldetag: 02.10.1997
(51) Int. Cl.: H05K 13/04

(54) **Verfahren und Vorrichtung zur Herstellung einer Ansaugfläche auf einem Gegenstand und Dadurch ausgebildetes elektrisches Bauteil**

(30) Priorität: 10.10.1996 DE 29617668 U
(71) Anmelder: Hagn, Erwin, 85368 Moosburg (DE)
(72) Erfinder: Hagn, Erwin, 85368 Moosburg (DE)
(74) Vertreter: KUHNEN, WACKER & PARTNER

(57) **Zusammenfassung**

Offenbart wird ein Verfahren und eine Vorrichtung zur Herstellung einer Ansaugfläche 6 auf einem Gegenstand, der vorzugsweise ein für die SMD-Montagetechnik vorgesehenes elektrisches Bauteil ist. Dabei wird die plane Ansaugfläche 6 auf der der Montageseite 5 gegenüberliegenden Oberfläche des Bauteils 1 dadurch ausgebildet, daß auf dem Bauteil 1 eine adhäsionsfähige Masse 21 aufgebracht und ein darüber angeordnetes Deckband 13 durch einen Stempel 40 derart auf die Masse 21 gedrückt wird, daß sich diese unter Ausbildung einer planen Fläche verformt. Nach dem Aushärten der adhäsionsfähigen Masse 21 wird das Deckband 13 von der Masse 21 abgetrennt und es entsteht ein Bauteil 1 mit einer planen Ansaugfläche 6 welche zum Beispiel von einer Saugpipette zuverlässig und problemlos angesaugt, dadurch aufgenommen und transportiert werden kann. Die adhäsionsfähige Masse 21 kann hierbei aus einem zu verflüssigenden oder verflüchtigenden Material wie beispielsweise Wachs, Kollophonium oder Kunststoff bestehen.

## Beschreibung

Die Erfindung betrifft ein Verfahren zur Herstellung einer Ansaugfläche auf einem Gegenstand, der vorzugsweise ein für die SMD-Montagetechnik vorgesehenes elektrisches Bauteil ist, wobei die Ansaugfläche auf einer der Montageseite gegenüberliegenden Oberfläche des in einem Bereitstellungsmodul vorliegenden Gegenstandes angeordnet wird. Ferner bezieht sich die Erfindung auf eine Vorrichtung zur Durchführung dieses Verfahrens und ein damit gebildetes elektrisches Bauteil, sowie ein Bereitstellungsmodul in einem Blistergurt.

Mit fortschreitender Technik wird eine zunehmende Miniaturisierung von Schaltungen und Schaltplatinen erreicht, was gleichzeitig mit einer Verringerung der Abmessungen der einzelnen elektrischen Bauteile verbunden ist. Dadurch erschwert sich die manuelle oder automatische Handhabung dieser Bauteile, zumal diese aufgrund der geringen Abmessungen häufig eine geringe Stabilität aufweisen.

Zur Verarbeitung derartiger elektrischer Bauteile ist es zum Beispiel bekannt, eine SMD-Bestückung auf Leiterplatten vorzunehmen. Hierzu werden die Bauteile zum Beispiel mittels einer Saugpipette aus einem Bereitstellungsmodul entnommen und exakt positioniert auf der Leiterplatte aufgesetzt.

Die zur Anwendung kommenden Bauteile weisen jedoch häufig eine im wesentlichen zylinderförmige Gestalt, wie zum Beispiel Widerstände, eine spiralförmige Gestalt, wie zum Beispiel elektrische Spulen, und andere von einer ebenen Oberfläche abweichenden Gestalten auf. Daher ist oftmals eine exakte Aufnahme durch die Saugpipette nicht möglich.

Um dieses Problem zu lösen, schlägt das Deutsche Gebrauchsmuster DE-GM 94 10 532 das Anbringen eines Plättchens auf der Bauteiloberseite vor. Dieses Plättchen wird durch ein Klebemittel am Bauteil befestigt und ist so angeordnet, daß auf der der Montageseite gegenüberliegenden Oberfläche des elektrischen Bauteils eine plane Fläche vorliegt. Die derart gestalteten Bauteile können zwar durch die Saugpipette korrekt aufgenommen werden, erfordern jedoch eine aufwendige Bestückung des elektrischen Bauteiles mit den Plättchen. Hierzu ist ein zusätzlicher Bearbeitungsschritt notwendig, der sehr exakt ausgeführt werden muß und daher einen hohen vorrichtungstechnischen Aufwand mit, entsprechendem Zeitbedarf erfordert.

Der Erfindung liegt daher die Aufgabe zugrunde, ein Verfahren und eine Vorrichtung zur Herstellung einer Ansaugfläche auf einem Gegenstand aufzuzeigen, mittels dem bzw. der auf einfache Weise eine plane Fläche auf dem Bauteil ausgebildet werden kann.

Diese Aufgabe wird verfahrenstechnisch dadurch gelöst, daß nach dem positionsrichtigen Einlegen des Gegenstandes in das Bereitstellungsmodul eine adhäsionsfähige Masse auf die Oberseite des Gegenstandes aufgebracht wird, ein Deckband über der adhäsionsfähigen Masse angeordnet wird, und ein Stempel derart Druck auf das Deckband ausübt, das auf der darunter befindlichen adhäsionsfähigen Masse eine plane Ansaugfläche entsteht.

Vorrichtungstechnisch wird diese Aufgabe ferner gelöst durch eine Dosiereinrichtung zum Aufbringen einer vorbestimmten Menge einer adhäsionsfähigen Masse auf den in einem Bereitstellungsmodul positionsrichtig vorliegenden Gegenstand, eine Vorrichtung zum Anordnen eines Deckbandes über der adhäsionsfähigen Masse, und einen Stempel, mit dem durch das Deckband auf die darunter befindliche adhäsionsfähige Masse eine plane Ansaugfläche drückbar ist.

Erfindungsgemäß wird daher in vorteilhafter Weise auch bei Bauelementen mit nicht planen Oberflächen eine plane Ansaugfläche bereitgestellt. Damit ist ein zuverlässiges und problemloses Ansaugen des Gegenstandes zum Beispiel durch einen Bestückungsautomaten gewährleistet.

Vorteilhafterweise können die Gegenstände daher bei einer Bestückung trotz ihrer geringen Abmessungen auch in der Massenproduktion zuverlässig aufgenommen und zum Beispiel zu einer Schaltplatine transportiert und dort exakt positioniert werden.

Zudem wird eine fehlerhafte Aufnahme der Gegenstände mittels einer Saugpipette vermieden, auch wenn sie an sich mit nicht planen Oberflächen ausgebildet sind. Ein Verkanten oder Herabfallen des Bauteiles beim Transport bzw. beim Aufsetzen auf die Schaltplatine wird daher wirksam vermieden.

Hierbei wurde überraschend erkannt, daß es erfindungsgemäß nicht notwendig ist, den Aufwand zur Anordnung eines Plättchens auf den Gegenstand zu betreiben. Statt dessen ist es bereits ausreichend, eine adhäsionsfähige Masse so zu verformen, daß diese eine plane Ansaugfläche bildet. Dadurch verringert sich der vorrichtungstechnische Aufwand gegenüber dem Stand der Technik wesentlich, da das exakte Aufbringen des Plättchens entfallen kann.

Von weiterem Vorteil ist es, daß die Bauteile zur Aufbringung der adhäsionsfähigen Masse nicht aus dem Bereitstellungsmodul entnommen werden müssen, da diese durch die Dosiereinrichting in exakt gesteuerter Weise vorgenommen werden kann.

Bei Verwendung eines Materials für die adhäsionsfähige Masse, das nach Bestückung bzw. Verarbeitung verflüchtigt bzw. verflüssigt werden kann, ist in vorteilhafter Weise z.B. ein nachträglicher Abgleich von SMD-Spulen möglich.

Vorteilhaft ist ferner, daß das ohnehin notwendige Deckband zum Abdecken des Bereitstellungsmoduls als Gegenfläche für die Herstellung der planen Ansaugfläche verwendet wird. Dadurch kann der Stempel einen Druck zur bleibenden Verformung der adhäsionsfähigen Masse ausüben, ohne daß die Gefahr besteht, daß der Stempel mit der adhäsionsfähigen Masse verklebt. Um Bestückungsfähige Gegenstände zu erhalten, ist es dann lediglich notwendig, das Deckband von den Gegenständen abzulösen.

Das erfindungsgemäße Verfahren und die entsprechende Vorrichtung können dabei in vorteilhafter Weise ohne weiteres in den Herstellungsprozeß derartiger Gegenstände einbezogen werden. Dadurch ist eine kontinuierliche Vorfertigung von elektrischen Bauteilen in einer Massenproduktion möglich.

Weitere vorteilhafte Ausgestaltungen der Erfindung ergeben sich aus den Merkmalen der Unteransprüche.

Dadurch, daß die adhäsionsfähige Masse durch eine entsprechende Aushärtevorrichtung ausgehärtet wird, kann der Aushärtevorgang der Klebeverbindung wirksam beschleunigt werden. Dies hat den Vorteil, daß der Zeitbedarf zur Herstellung der erfindungsgemäßen Gegenstände mit einer planen Ansaugfläche weiter verringert wird. Das Aushärten wird dabei vorzugsweise durch eine Beaufschlagung mit Energie elektromagnetischer Strahlung, insbesondere von Licht im sichtbaren Bereich, durchgeführt. Damit die Strahlung auf die unter dem Deckband angeordnete adhäsionsfähige Masse einwirken kann, ist das Deckband hierbei strahlungsdurchlässig ausgebildet. Damit kann auf einfache Weise unter Nutzung bekannter Bestrahlungstechnologien eine wirksame Aushärtung erreicht werden.

Wenn das Deckband nach der Herstellung der planen Ansaugfläche durch eine Abstreifvorrichtung vom Gegenstand getrennt wird, liegen die Gegenstände mit der planen Ansaugfläche einzeln und in weiterverwendbaren Zustand im Bereitstellungsmodul vor.

Von weiterem Vorteil ist es, wenn nach dem Abstreifen des Deckbandes erneut ein Deckband auf der Oberfläche des Bereitstellungsmoduls angeordnet und vorzugsweise durch Verschweißen befestigt wird. Dabei wird vorzugsweise das zuvor abgetrennte Deckband erneut verwendet. Dann kann das Deckband sowohl die Funktion als Gegenfläche zur Ausbildung der planen Ansaugfläche, als auch zum sicheren Abschließens des Bereitstellungsmoduls gegen einen Verlust von Bauteilen verwendet werden. Zur Ausbildung der erfindungsgemäßen planen Ansaugfläche ist daher kein zusätzliches Deckband notwendig. Der Aufwand zur Herstellung der Ansaugfläche verringert sich dadurch weiter.

Dadurch, daß ein aus mehreren Bereitstellungsmodulen gebildeter Blistergurt verwendet wird, ist eine kontinuierliche Herstellung des erfindungsgemäßen Bauteiles möglich. Der Blistergurt ermöglicht einen Durchlauf der Bauteile durch die erfindungsgemäße Vorrichtung und verringert dadurch den konstruktiven Aufwand für die Vorrichtung.

Gemäß einem weiteren Aspekt der Erfindung wird ein Bauteil, vorzugsweise ein elektrisches Bauteil aufgezeigt, welches eine durch das erfindungsgemäße Verfahren gebildete plane Ansaugfläche aufweist. Dieses Bauteil ist dahingehend vorteilhaft, daß es im Gegensatz zum Stand der Technik weniger Bestandteile aufweist und daher einfacher herzustellen ist. Es erlaubt zudem die gewünschte sichere Aufnahme, einen zuverlässigen Transport und ein exaktes Positionieren des Bauteiles durch eine Saugpipette oder ähnliches. Das Bauteil kann daher vollautomatisch an einer Leiterplatte bestückt werden.

Gemäß noch einem weiteren Aspekt der Erfindung wird ein Bereitstellungsmodul, insbesondere in einem Blistergurt geschaffen, der eine vorzugsweise punktuell vorliegende Kennzeichnungsschicht am Deckband aufweist. Diese Kennzeichnungsschicht gibt dem Nutzer Aufschluß darüber, daß der Gegenstand im Blistergurt eine plane Ansaugfläche aufweist, die nach dem erfindungsgemäßen Verfahren hergestellt wurde. Damit wird die automatisierte Bestückungseignung des Gegenstandes im Blistergurt erkennbar. Hierbei ist von wesentlichem Vorteil, daß diese Kennzeichnungsschicht bei der Herstellung der planen Ansaugfläche am Gegenstand vorzugsweise zwangsläufig durch Rückstände der ausgehärteten adhäsionsfähigen Masse ausgebildet wird. Eine gesonderte Kennzeichnung am Blistergurt ist daher nicht notwendig.

Die Erfindung wird nachfolgend in Ausführungsformen anhand der Figuren der Zeichnung näher erläutert. Es zeigt:
Fig. 1 eine Seitenansicht eines erfindungsgemäßen elektrischen Bauteiles im vergrößerten Maßstab;
Fig. 2 eine Vorderansicht des erfindungsgemäßen elektrischen Bauteils in einem vergrößerten Maßstab; und
Fig. 3 eine Vorrichtung zur Durchführung des Verfahrens zur Herstellung der Ansaugfläche auf dem Bauteil.

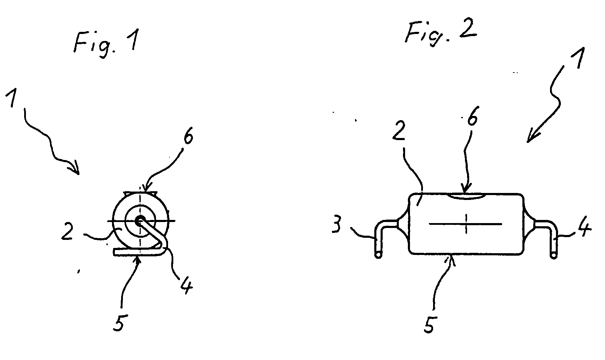

In den Figuren 1 und 2 ist ein elektrisches Bauteil dargestellt, welches beispielhaft für die Vielzahl an Anwendungsmöglichkeiten der Erfindung anzusehen ist. In diesen Figuren ist eine Drosselspule 1 dargestellt, die einen im wesentlichen zylinderförmigen Hauptkörper 2 und Anschlußdrähte 3 und 4 aufweist. Ferner ist einer Montageseite 5 gegenüberliegend eine plane Ansaugfläche 6 am Hauptkörper 2 der Drossel 1 ausgebildet.

Diese Drosselspule 1 ist daher geeignet, von einer nicht dargestellten Saugpipette in bekannter Weise angesaugt, aufgenommen und zu einer Schaltplatine oder ähnlichem transportiert sowie dort exakt aufgesetzt zu werden.

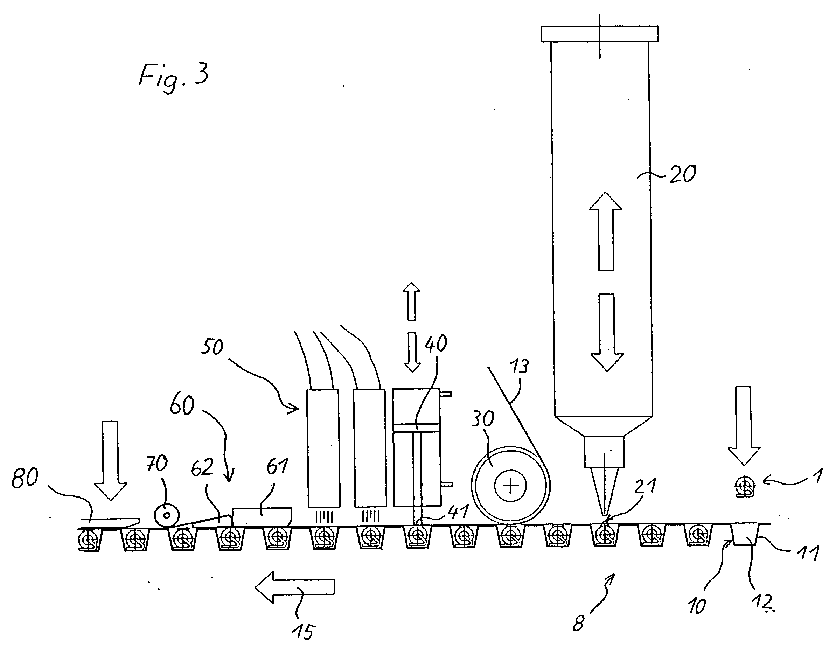

Die Verfahrensschritte zur Herstellung der Ansaugfläche 6 auf der Drossel 1 werden nachfolgend anhand Fig. 3 erläutert.

Gemäß der Darstellung in dieser Figur werden die Drosseln 1 in bekannter Weise zum Beispiel durch einen Rüttel- bzw. Schneckenförderer lagemäßig richtig orientiert in einem aus mehreren Bereitstellungsmodulen 10 gebildeten Blistergurt 8 angeordnet. Der Blistergurt 8 weist einen Blisterkörper 11 mit Vertiefungen 12 zur Aufnahme der Drosseln 1 auf. Der Blistergurt 8 bewegt sich dabei in Richtung des Pfeiles 15 schrittweise voran.

Nachfolgend ist eine Dosiereinrichtung 20 vorgesehen, um eine adhäsionsfähige Masse 21 in exakt gesteuerter Weise auf der der Montageseite 5 gegenüberliegenden Oberfläche der Drossel 1 aufzubringen. Die Menge der adhäsionsfähigen Masse wird dabei so gewählt, daß eine ausreichend große plane Ansaugfläche 6 an der Drossel 1 ausgebildet werden kann. Je nach Gestalt und Größe des Bauteiles kann die Menge der adhäsionsfähigen Masse 21 daher variieren.

Im Anschluß daran wird mittels einer Vorrichtung 30 ein durchsichtiges Deckband 13 über den Drosseln 1 und damit über der adhäsionsfähigen Masse 21 aufgebracht. Die Vorrichtung 30 ist in dieser Ausführungsform eine Umlenkwalze, welche das zum Beispiel von einer Rolle zugeführte Deckband 13 auf den Blistergurt 8 umlenkt.

Anschließend wird ein Stempel 40 aktiviert, der gemäß der Darstellung in Fig. 3 vertikal zur Laufrichtung des Blistergurtes 8 hin und her bewegbar ist. Das Fortschreiten des Blistergurts 8 wird dabei so angesteuert, daß Der Stempel 40 jeweils über der adhäsionsfähigen Masse 21 auf der jeweiligen Drossel 1 zu liegen kommt und das Deckband 13 an dieser Stelle auf die adhäsionsfähige Masse 21 drückt. Die adhäsionsfähige Masse 21 verformt sich dadurch und bildet gemäß der Gestalt der ebenen Stirnfläche 41 des Stempels 40 eine plane Fläche aus.

Durch die Adhäsionskraft der Masse 21 liegt das Deckband 13 somit verklebt mit der jeweiligen Drossel 1 vor.

Nachfolgend wird die adhäsionsfähige Masse durch eine Aushärtevorrichtung 50 durch Aufbringen von Strahlungsenergie ausgehärtet. In Fig. 3 sind zwei zusammenwirkende Elemente der Aushärtevorrichtung 50 dargestellt, die für eine ausreichende Aushärtestrecke mit UV-Licht sorgen. Das Deckband 13 ist dabei durchlässig für das UV-Licht ausgebildet.

Im nächsten Verfahrensschritt wird das Deckband 13 durch eine Abstreifvorrichtung 60 von der ausgehärteten Masse 21 auf der Drossel 1 abgetrennt. Die Abstreifvorrichtung 60 weist hierzu einen Niederhalter 61 und einen Abstreifer 62 auf. Zwischen dem Niederhalter 61 und dem Abstreifer 62 wird das Deckband 13 in aufrechter Richtung bezüglich der Laufrichtung des Blistergurtes 8 umgelenkt und weitergeführt. Die Ausgestaltung des Abstreifers 62 und des Niederhalters 61 sorgt dabei dafür, daß die Drosseln 1 nicht aus dem Blistergurt 8 herausgehoben werden.

Da die Masse 21 bereits ausgehärtet ist, behält sie hierbei ihre Gestalt als plane Fläche bei. Von Bedeutung ist, daß die Materialien des Deckbandes 13 und der adhäsionsfähigen Masse 21 so gewählt werden, daß die adhäsionsfähige Masse 21 beim Abstreifen des Deckbandes 13 auf der Drossel 1 verbleibt und nur unwesentliche Rückstände am Deckband 13 auftreten. Da das Deckband 13 durchsichtig ausgestaltet ist, sind die Rückstände der Masse 21 am Deckband 13 erkennbar und dienen als Kennzeichnungsschicht, welche anzeigt, daß der Gegenstand im Blistergurt 8 nach dem erfindungsgemäßen Verfahren ausgebildet ist und eine plane Ansaugfläche aufweist.

Nachfolgend ist eine Deckbandaufbringvorrichtung 70 in Gestalt einer Rolle vorgesehen, die das abgetrennte Deckband 13 erneut auf den Blistergurt 8 aufbringt. Durch eine Schweißeinrichtung 80 wird das Deckband 13 schließlich mit dem Blistergurt 8 verschweißt, wodurch ein Herausfallen der jeweiligen Drosseln 1 beim Transport wirksam verändert wird. Da die Verbindung des Deckbandes 13 zur Masse 21 durch die Abstreifvorrichtung 60 aufgehoben wurde, liegen die Drosseln 1 damit lose in den Vertiefungen des Blistergurts 8 vor.

Die Erfindung läßt neben dem hier aufgezeigten Ausführungsbeispiel weitere Gestaltungsansätze zu.

So kann die adhäsionsfähige Masse 21 auch durch einen entsprechend gewählten Zusatz ausgehärtet werden, so daß die Aushärtevorrichtung 50 entfallen kann.

Ferner ist es auch möglich, auf die Abstreifvorrichtung 60 zu verzichten und die Trennung zwischen dem Deckband 13 und der Masse 21 unmittelbar vor der Bestückung der Drosseln 1 durchzuführen. Hierzu kann auch eine beliebig andersartig gestaltete Abstreifvorrichtung verwendet werden, die lediglich ein zuverlässige Trennung zwischen dem Deckband 13 und der Masse 21 bewirken muß, ohne daß die plane Ausgestaltung der Ansaugfläche 6 wesentlich beeinträchtigt wird.

Anstelle der erneuten Zuführung des Deckbandes 13 nach dem Abstreifen durch die Abstreifvorrichtung 60 kann auch ein weiteres Deckband von einer anderen Zuführrolle durch die Vorrichtung 70 dem Blistergurt 8 zugeführt und darauf angeordnet werden. Dann müßte lediglich dafür gesorgt werden, daß das Deckband 13 hinter der Abstreifvorrichtung 60 zuverlässig weggeführt wird.

Der Stempel 40 kann an sich eine beliebige Gestalt und Ansteuerungsweise haben, wobei er lediglich geeignet sein muß, um die Masse 21 so zu verformen, daß sie an der Oberfläche eine plane Fläche bildet.

Das beschriebene Verfahren und die entsprechende Vorrichtung können an elektrischen Bauteilen unterschiedlichster Gestalt und Größe angewendet werden. Darüber hinaus ist es auch möglich, das Verfahren und die Vorrichtung zum Beispiel im Mechanikbereich zum Ausbilden von Ansaugflächen auf zumeist kleinen Bauteilen anzuwenden, um einen Weitertransport dieser zu ermöglichen. Besondere Anwendungsfälle liegen hier insbesondere in einer automatisierten mechanischen Montage. Die Erfindung läßt sich schließlich insbesondere in all jenen Fällen anwenden, in denen ein beliebiger Gegenstand einer bestimmten Oberflächenform erhalten muß, damit er zum Beispiel durch eine Saugpipette oder ein anderes in der Bestückungstechnik übliches Werkzeug sicher und zuverlässig aufgenommen und transportiert werden kann.

Insbesondere für die Bestückung von beweglichen derartigen mechanischen Bauteilen aber auch elektrischen Bauteilen, die beispielsweise als Spule nach der Bestückung noch abgeglichen werden müssen, kann für die adhäsionsfähige Masse ein Material verwendet werden, das sich bei einer späteren Verarbeitung nach der Montage verflüssigen, verdampfen oder verflüchtigen läßt. Vorzugsweise erfolgt dieses Verflüssigen bzw. Verflüchtigen durch eine Erwärmung der Ansaugfläche, bei der sich zwar die adhäsionsfähige Masse verflüssigt bzw. verflüchtigt, jedoch das Lot bzw. Befestigungsmittel zum Befestigen des Bauteils auf einer Platine oder in einem System weiterhin fest bleibt.

Gemäß einem bevorzugten Ausführungsbeispiel besteht das sich verflüchtigende bzw. verflüssigende Material aus Wachs, Kollophonium und/oder Kunststoff, das sich bei einer Löttemperatur (Reflow-Löten) von beispielsweise 230° bis 250°C verflüchtigt bzw. abfließt. Dadurch erhält man beispielsweise eine Spule, deren Windungen nach dem Einlöten nachträglich abgeglichen werden können. Ferner eignet sich ein derartiges Material auch für bewegliche mechanische Bauteile, die als SMD-Bauteile verarbeitet werden sollen, wobei die die Beweglichkeit des mechanischen Bauteils blockierende Ansaugfläche durch eine Erwärmung bzw. Bestrahlung verflüchtigt bzw. verflüssigt werden kann.

Ferner kann anstelle des beschriebenen Blistergurts 8 auch ein anderes geeignetes Bereitstellungsmodul 10 verwendet werden. Derartige Bereitstellungsmodule 10 sind wie z.B. Mikropack-Zuführungen von der Rolle einschlägig bekannt und dem Fachmann geläufig.

Um eine Massenbearbeitung zu ermöglichen, kann die erfindungsgemäße Vorrichtung zudem mehrfach parallel geschaltet angeordnet sein.

Die Erfindung zeigt somit ein Verfahren und eine Vorrichtung zur Herstellung einer Ansaugfläche 6 auf einem Gegenstand, der vorzugsweise ein für die SMD-Montagetechnik vorgesehenes elektrisches Bauteil ist. Ferner schafft die Erfindung ein elektrisches Bauteil 1, das auf der der Montageseite 5 gegenüberliegenden Oberfläche eine plane Ansaugfläche 6 aufweist. Diese Ansaugfläche 6 wird dabei dadurch ausgebildet, daß auf dem Bauteil 1 eine adhäsionsfähige Masse 21 aufgebracht und ein darüber angeordnetes Deckband 13 durch einen Stempel 40 derart auf die Masse 21 gedrückt wird, daß sich diese unter Ausbildung einer planen Fläche verformt. Nach dem Aushärten der adhäsionsfähigen Masse 21 wird das Deckband 13 von der Masse 21 abgetrennt und es entsteht ein Bauteil 1 mit einer planen Ansaugfläche 6 welche zum Beispiel von einer Saugpipette zuverlässig und problemlos angesaugt, dadurch aufgenommen und transportiert werden kann.

## Patentansprüche

1. Verfahren zur Herstellung einer Ansaugfläche (6) auf einem Gegenstand (1), der vorzugsweise ein für die SMD-Montagetechnik vorgesehenes elektrisches Bauteil ist, wobei die Ansaugfläche (6) auf einer der Montageseite (5) gegenüberliegenden Oberfläche des in einem Bereitstellungsmodul (10) vorliegenden Gegenstandes (1) angeordnet wird, dadurch gekennzeichnet, daß
a) nach dem positionsrichtigen Einlegen des Gegenstandes (1) in das Bereitstellungsmodul (10) eine adhäsionsfähige Masse (21) auf die Oberseite des Gegenstandes (1) aufgebracht wird,
b) ein Deckband (13) über der adhäsionsfähigen Masse (21) angeordnet wird, und
c) ein Stempel (40) derart Druck auf das Deckband (13) ausübt, daß auf der darunter befindlichen adhäsionsfähigen Masse (21) eine plane Ansaugfläche (6) entsteht.

2. Verfahren nach Anspruch 1, dadurch gekennzeichnet, daß die adhäsionsfähige Masse (21) ausgehärtet wird.

3. Verfahren nach einem der Ansprüche 1 oder 2, dadurch gekennzeichnet, daß die adhäsionsfähige Masse (21) aus einem Material besteht, das sich bei einer späteren Erwärmung oder Bestrahlung verflüssigt oder verflüchtigt.

4. Verfahren nach Anspruch 3, dadurch gekennzeichnet, daß die adhäsionsfähige Masse (21) aus Wachs, Kollophonium oder Kunststoff besteht.

5. Verfahren nach Anspruch 2, dadurch gekennzeichnet, daß die adhäsionsfähige Masse (21) durch Bestrahlung insbesondere durch elektromagnetische Strahlung ausgehärtet wird, wobei das Deckband (13) strahlungsdurchlässig ausgebildet ist.

6. Verfahren nach einem der Ansprüche 1 bis 5, dadurch gekennzeichnet, daß das Deckband (13) nach der Herstellung der planen Ansaugfläche (6) durch eine Abstreifvorrichtung (60) vom Gegenstand (1) abgetrennt wird.

7. Verfahren nach einem der Ansprüche 1 bis 6, dadurch gekennzeichnet, daß nach dem Abtrennen des Deckbandes (13) ein Deckband auf der Oberfläche des Bereitstellungsmoduls (10) angeordnet und vorzugsweise durch Verschweißen befestigt wird.

8. Verfahren nach Anspruch 7, dadurch gekennzeichnet, daß das auf der Oberfläche des Bereitstellungsmoduls (10) angeordnete Deckband das zuvor abgetrennte Deckband (13) ist.

9. Verfahren nach einem der Ansprüche 1 bis 8, dadurch gekennzeichnet, daß als Bereitstellungsmodul (10) ein Blistergurt (8) verwendet wird.

10. Vorrichtung zur Durchführung eines Verfahrens zur Herstellung einer Ansaugfläche (6) auf einem Gegenstand (1), der vorzugsweise ein für die SMD-Montagetechnik vorgesehenes elektrisches Bauteil ist, insbesondere nach einem der Ansprüche 1 bis 8, gekennzeichnet durch
a) eine Dosiereinrichtung (20) zum Aufbringen einer vorbestimmten Menge einer adhäsionsfähigen Masse (21) auf den in einem Bereitstellungsmodul (10) positionsrichtig vorliegenden Gegenstand (1),
b) eine Vorrichtung (30) zum Anordnen eines Deckbandes (13) über der adhäsionsfähigen Masse (21), und
c) einen Stempel (40), mit dem durch das Deckband (13) auf die darunter befindliche adhäsionsfähige Masse (21) eine plane Ansaugfläche (6) drückbar ist.

11. Vorrichtung nach Anspruch 10, dadurch gekennzeichnet, daß eine Aushärtevorrichtung (50) zum Aushärten der adhäsionsfähigen Masse (21) vorgesehen ist.

12. Vorrichtung nach Anspruch 10 oder 11, dadurch gekennzeichnet, daß die von der Dosiereinrichtung (20) aufgebrachte adhäsionsfähige Masse (21) aus einem Material besteht, das sich bei einer späteren Erwärmung oder Bestrahlung verflüssigt oder verflüchtigt.

13. Vorrichtung nach Anspruch 12, dadurch gekennzeichnet, daß die von der Dosiereinrichtung (20) aufgebrachte adhäsionsfähige Masse (21) aus Wachs, Kollophonium oder Kunststoff besteht.

14. Vorrichtung nach Anspruch 11, dadurch gekennzeichnet, daß die Aushärtevorrichtung (50) vorzugsweise elektromagnetische Strahlung abgibt, und wobei das Deckband (13) strahlungsdurchlässig ausgebildet ist.

15. Vorrichtung nach einem der Ansprüche 10 bis 14, dadurch gekennzeichnet, daß eine Abstreifvorrichtung (60) zum Abtrennen des Deckbandes (13) vom Gegenstand (1) vorgesehen ist.

16. Vorrichtung nach einem der Ansprüche 10 bis 15, dadurch gekennzeichnet, daß ferner eine Deckbandaufbringvorrichtung (70) zum Aufbringen eines Deckbandes auf das Bereitstellungsmodul (10) vorgesehen ist, wobei vorzugsweise das zuvor abgetrennte Deckband (13) erneut aufgebracht wird.

17. Vorrichtung nach Anspruch 16, dadurch gekennzeichnet, daß eine Schweißeinrichtung (80) zum Verschweißen des Deckbandes (13) mit dem Bereitstellungsmodul (10) vorgesehen ist.

18. Vorrichtung nach einem der Ansprüche 10 bis 17, dadurch gekennzeichnet, daß mehrere Bereitstellungsmodule (10) in einem Blistergurt (8) ausgebildet sind.

19. Bauteil, vorzugsweise elektrisches Bauteil (1), dadurch gekennzeichnet, daß es eine plane Ansaugfläche (6) aufweist, die durch ein Verfahren nach einem der Ansprüche 1 bis 9 oder mit einer Vorrichtung nach einem der Ansprüche 10 bis 18 hergestellt ist.

20. Bereitstellungsmodul (10), insbesondere in einem Blistergurt (8), mit einem Blisterkörper (11) und einem durchsichtigen Deckband (13), dadurch gekennzeichnet, daß das Deckband (13) eine vorzugsweise punktuell ausgebildete Kennzeichnungsschicht aufweist, welche vorzugsweise aus den Rückständen einer abgetrennten adhäsionsfähigen Masse (21) besteht.
